# EUROPEAN PATENT SPECIFICATION

(11) **EP 3 707 561 B1**
(45) Date of publication and mention of the grant of the patent: **19.08.2026**
(21) Application number: 18876413.8
(22) Date of filing: 29.10.2018
(51) Int. Cl.: B22F 10/50, B22F 10/28, B22F 10/66, B29C 64/153, B22F 12/90, B33Y 10/00, B33Y 30/00, B33Y 50/02, B29C 64/393, B22F 10/85, B22F 3/16, B22F 10/25, B22F 12/49, B22F 12/67

(54) **METHODS FOR BUILD SURFACE MAPPING**
VERFAHREN ZUM AUFBAU VON OBERFLÄCHENABBILDUNG
PROCÉDÉS DE CARTOGRAPHIE DE SURFACE DE CONSTRUCTION

(30) Priority: 08.11.2017 US 201715807443
(43) Date of publication of application: 16.09.2020
(73) Proprietor: General Electric Company, Schenectady, NY 12345 (US)
(72) Inventor: JONES, Lucas, Christian, West Chester, Ohio 45069 (US); MAMRAK, Justin, West Chester, Ohio 45069 (US)
(74) Representative: Hafner & Kohl PartmbB
(86) International application number: PCT/US2018/058009
(87) International publication number: WO 2019/094217

(56) References cited:
- WO-A1-2017/085468
- US-A1- 2002 104 973
- US-A1- 2013 101 729
- US-A1- 2014 358 273
- US-A1- 2015 174 658
- US-A1- 2015 266 242
- US-A1- 2016 023 403
- US-A1- 2017 239 719

## Description

### TECHNICAL FIELD

The present disclosure generally relates to additive manufacturing (AM) methods to perform additive manufacturing processes. More specifically, the present disclosure relates to methods that enable a continuous process of additively manufacturing components, such as but not limited to components of an aircraft engine.

### BACKGROUND

Additive manufacturing (AM) techniques may include electron beam freeform fabrication, laser metal deposition (LMD), laser wire metal deposition (LMD-w), gas metal arc-welding, laser engineered net shaping (LENS), laser sintering (SLS), direct metal laser sintering (DMLS), electron beam melting (EBM), powder-fed directed-energy deposition (DED), and three dimensional printing (3DP), as examples. AM processes generally involve the buildup of one or more materials to make a net or near net shape (NNS) object in contrast to subtractive manufacturing methods. Though "additive manufacturing" is an industry standard term (ASTM F2792), AM encompasses various manufacturing and prototyping techniques known under a variety of names, including freeform fabrication, 3D printing, rapid prototyping/tooling, etc. AM techniques are capable of fabricating complex components from a wide variety of materials. Generally, a freestanding object can be fabricated from a computer aided design (CAD) model. As an example, a particular type of AM process uses an energy beam, for example, an electron beam or electromagnetic radiation such as a laser beam, to sinter or melt a powder material and/or wire-stock, creating a solid three-dimensional object in which a material is bonded together.

Selective laser sintering, direct laser sintering, selective laser melting, and direct laser melting are common industry terms used to refer to producing three-dimensional (3D) objects by using a laser beam to sinter or melt a fine powder. For example, U.S. Patent Number 4,863,538 and U.S. Patent Number 5,460,758 describe conventional laser sintering techniques. More specifically, sintering entails fusing (agglomerating) particles of a powder at a temperature below the melting point of the powder material, whereas melting entails fully melting particles of a powder to form a solid homogeneous mass. The physical processes associated with laser sintering or laser melting include heat transfer to a powder material and then either sintering or melting the powder material. Electron beam melting (EBM) utilizes a focused electron beam to melt powder. These processes involve melting layers of powder successively to build an object in a metal powder.

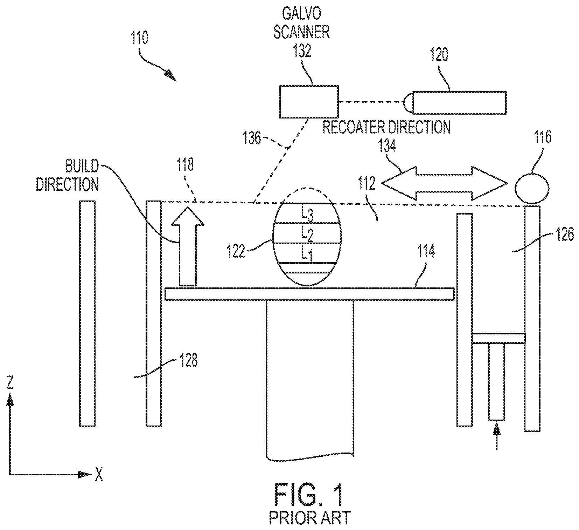

FIG. 1 is schematic diagram showing a cross-sectional view of an exemplary conventional system 110 for direct metal laser sintering (DMLS) or direct metal laser melting (DMLM). The apparatus 110 builds objects, for example, the part 122, in a layer-by-layer manner (e.g. layers L1, L2, and L3, which are exaggerated in scale for illustration purposes) by sintering or melting a powder material (not shown) using an energy beam 136 generated by a source such as a laser 120. The powder to be melted by the energy beam is supplied by reservoir 126 and spread evenly over a build plate 114 using a recoater arm 116 travelling in direction 134 to maintain the powder at a level 118 and remove excess powder material extending above the powder level 118 to waste container 128. The energy beam 136 sinters or melts a cross sectional layer (e.g. layer L1) of the object being built under control of the galvo scanner 132. The build plate 114 is lowered and another layer (e.g. layer L2) of powder is spread over the build plate and object being built, followed by successive melting/sintering of the powder by the laser 120. The process is repeated until the part 122 is completely built up from the melted/sintered powder material. The laser 120 may be controlled by a computer system including a processor and a memory. The computer system may determine a scan pattern for each layer and control laser 120 to irradiate the powder material according to the scan pattern. After fabrication of the part 122 is complete, various post-processing procedures may be applied to the part 122. Post processing procedures include removal of excess powder, for example, by blowing or vacuuming, machining, sanding or media blasting. Further, conventional post processing may involve removal of the part 122 from the build platform/substrate through machining, for example. Other post processing procedures include a stress release process. Additionally, thermal and chemical post processing procedures can be used to finish the part 122.

The abovementioned AM processes is controlled by a computer executing a control program. For example, the apparatus 110 includes a processor (e.g., a microprocessor) executing firmware, an operating system, or other software that provides an interface between the apparatus 110 and an operator. The computer receives, as input, a three dimensional model of the object to be formed. For example, the three dimensional model is generated using a computer aided design (CAD) program. The computer analyzes the model and proposes a tool path for each object within the model. The operator may define or adjust various parameters of the scan pattern such as power, speed, and spacing, but generally does not program the tool path directly. One having ordinary skill in the art would fully appreciate the abovementioned control program may be applicable to any of the abovementioned AM processes. Further, the abovementioned computer control may be applicable to any subtractive manufacturing or any pre or post processing techniques employed in any post processing or hybrid process.

When forming a component using an AM process, various process parameters of the AM apparatus during a layer-by-layer build can have a significant impact on the quality of the component and the dimensional accuracy of the completed component. AM apparatuses have a significant number of components which all must be calibrated to create consistent and dimensionally accurate components. For example, an in the abovementioned apparatus, a galvanometer may be used to direct a laser beam to fuse a region of powder during each layer of the build. In the example, correct calibration of the galvanometer is critical to assure an accurate build. Further, in the AM apparatus disclosed below, there also exists a need to calibrate the movement of a build unit and/or a build platform.

During the building or growing process, however, some additively manufactured components may fracture or distort because the powder bed, due to part shrinkage, exerts excessive pressure on the growing part. Powder trapped within a growing part, or between the part and the powder box walls, can exert excessive pressure on the part causing part fractures and distortion. Additionally, powder trapped between the powder chamber floor and grown part limits the ability of the part to shrink as it cools which can result in distortion. Various other factors may result in a grown part warping or distorting during the build process. As a build progresses, small distortions or warped regions may result increasingly large dimensional inaccuracies. Such inaccuracies may result in an unusable component and/or may result in the recoater and/or build unit colliding with the warped portion during the build. Thus, the need exists to effectively monitor the dimensional accuracy of the build during the build process. Further, the need exists to compensate for the abovementioned dimensional inaccuracies by altering various process parameters during the build process.

US 2002/104973 A1, US 2013/101729 A1 and US 2014/358273 A1 are related prior art documents in the field of additive manufacturing and build surface correction.

### SUMMARY OF THE INVENTION

In one aspect, a method of fabricating an object by additive manufacturing is described. The method includes determining the topography of a build surface and modifying the additive manufacturing process based on the determined topography. Determining the topography of the surface includes marking the build surface with a first mark using a converging energy source; determining a dimension of the mark using a camera; and determining a height of the first mark abased on the dimension of the mark. The method further includes steps of determining a location of a depressed area of the build surface based on the determined topography, and filling in the depressed area in order to reduce variations in the topography of the build surface. The filling in of the depressed area comprises steps of: depositing a layer of build material over the depressed area of the build surface; fusing at least a portion of the layer of the build material at the depressed area of the surface; depositing a subsequent layer of powder over the depressed area of the build; and repeating the above-mentioned steps until the filling in of the depressed area is complete. The method of fabricating an object further comprises determining a location of protruded area of the surface based on the determined topography and performing a leveling operation to the surface to reduce variations in the topography of the build surface. A leveling operation includes a laser shot peening and/or ablation process to a protruded area of the build surface.

The method may further include repeating the abovementioned steps at multiple locations on the surface and comparing the determined height of the marks at the multiple locations on the surface. The method may also include repeating the abovementioned steps on multiple surfaces and comparing the determined height of the marks at said multiple surfaces, the methods used throughout may be used in combination with a laser interferometry method of build surface mapping.

In another aspect not encompassed by the wording of the claims, a non-transitory computer readable medium storing a program configured to cause a computer to execute a method for determining a topography of a surface during an additive manufacturing apparatus is disclosed. The method may include marking the surface with a first mark using converging energy source, determining a dimension of the mark using a camera; and determining the height of the first mark based on the dimension of the mark. The method may further include repeating the abovementioned steps at multiple locations on the surface and comparing the determined height of the marks at the multiple locations on the surface. The method may also include repeating the abovementioned steps on multiple surfaces and comparing the determined height of the marks at said multiple surfaces.

### BRIEF DESCRIPTION OF THE DRAWINGS

The accompanying drawings, which are incorporated into and constitute a part of this specification, illustrate one or more example aspects of the present disclosure and, together with the detailed description, serve to explain their principles and implementations.
FIG. 1 is a side view diagram of a conventional additive manufacturing technique used to form at least part of a component;
FIG. 2 is a side view cross section of a build unit in accordance with one aspect of the disclosure;
FIG. 3 is a side view cross section of a build unit and part of a mobile build platform of an additive manufacturing apparatus in accordance with one aspect of the disclosure;
FIG. 4 is a simplified side view of an additive manufacturing apparatus with a camera according to an aspect of the disclosure;
FIG. 5 is a simplified side view of an additive manufacturing apparatus with two converging energy sources in accordance with one aspect of the disclosure;
FIG. 6A-C are simplified side views of an additive manufacturing apparatus at various example positions during a leveling operation in accordance with one aspect of the disclosure;
FIG. 7 is a flowchart showing one example of a calibration process of an additive manufacturing machine in accordance with one aspect of the disclosure not according to the wording of the claims;
FIG. 8 is a flowchart showing one example of a calibration process of an additive manufacturing machine in accordance with one aspect of the disclosure.

### DETAILED DESCRIPTION

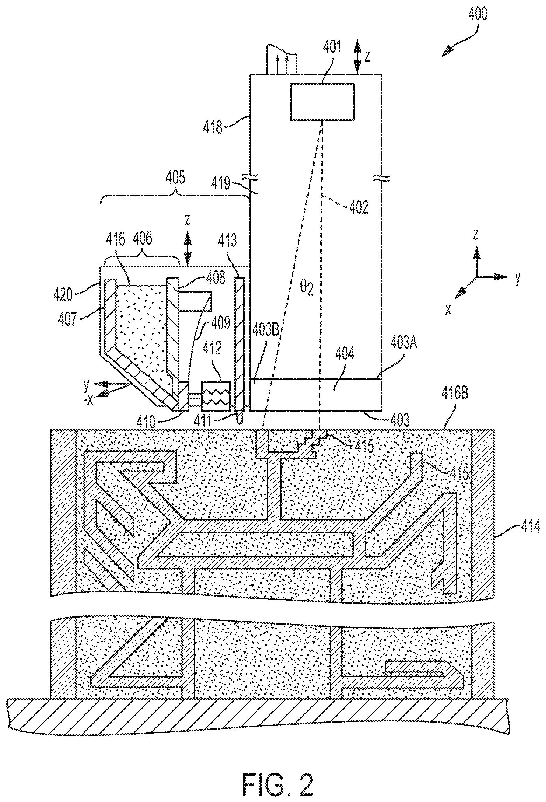

FIG. 2 is a diagram of a side view of a build unit, according to an embodiment of the present invention. FIG. 2 shows a build unit 400 including an irradiation emission directing device 401, a gasflow device 403 with a pressurized outlet portion 403A and a vacuum inlet portion 403B providing gas flow to a gasflow zone 404, and a recoater 405. An enclosure 418 containing an inert environment 419 may be provided above the gasflow zone 404. The recoater 405 may include a hopper 406 having a back plate 407 and a front plate 408. The recoater 405 may also include at least one actuating element 409, at least one gate plate 410, a recoater blade 411, an actuator 412, and a recoater arm 413. The recoater may be mounted to a mounting plate 420. FIG. 2 also shows a build envelope 414 that may be built by, for example, additive manufacturing or Mig/Tig welding, an object being formed 415, and powder 416 contained in the hopper 406 used to form the object 415. In this particular embodiment, the actuator 412 may activate the actuating element 409 to pull the gate plate 410 away from the front plate 408. In an alternative embodiment, the actuator 412 may be, for example, a pneumatic actuator, and the actuating element 409 may be a bidirectional valve. In yet another embodiment, the actuator 412 may be, for example, a voice coil, and the actuating element 409 may be a spring. There may also be provided a hopper gap 417 between the front plate 408 and the back plate 407 that allows powder to flow when a corresponding gate plate pulls away from the powder gate by an actuating element. The powder 416, the back plate 407, the front plate 408, and the gate plate 410 may all be the same material. Alternatively, the back plate 407, the front plate 408, and the gate plate 410 may all be the same material, and that material may be one compatible with the powder material such as, for example, cobalt-chrome. In the present exemplary embodiment of the present invention, the gas flow in the gasflow zone 404 flows in the y direction, but is not limited thereto. The recoater blade 411 may have a width in the x direction. The direction of the irradiation emission beam when θ2 is approximately 0 defines the z direction in this view. The gas flow in the gasflow zone 404 may be substantially laminar. The irradiation emission directing device 401 may be independently movable by a second positioning system (not shown). This illustration shows the gate plate 410 in the closed position.

The apparatus 400 may include a positioning mechanism (not shown), the maximum build area may be defined by the positioning mechanism, instead of by a powder bed as with conventional systems, and the build area for a particular build may be confined to a build 5 envelope 414 that may be dynamically built up along with the object. The positioning mechanism or gantry may include an x crossbeam (not shown) that moves the build unit 400 in the x direction. There may be two y crossbeams that move the build unit 400 and the x crossbeam in the y direction. The x cross beam and the build unit 400 may be attached by a mechanism that moves the build unit 400 in the z direction. The present invention is not limited thereto and may utilize other multidimensional positioning systems such as, for example, a delta robot, cable robot, or robot arm. The irradiation emission directing device 401 may be independently moved inside of the build unit 400 by a second positioning system (not shown).

The irradiation source directing device 401 may include an irradiation source that, in the case of a laser source, originates the photons comprising the laser irradiation that is directed by the irradiation emission directing device. The laser source may be a converging laser source which may be focused using a lens and/or series of lenses and/or a mirror and/or series of mirrors. The irradiation emission directing device may be, for example, a galvo scanner, and the laser source may be located outside the build environment. Under these circumstances, the laser irradiation may be transported to the irradiation emission directing device by any suitable means, for example, a fiber-optic cable. When the irradiation source is an electron source, then the electron source originates the electrons that comprise the e-beam that is directed by the irradiation emission directing device. When the irradiation source is an electron source, then the irradiation emission directing device may be, for example, a deflecting coil.

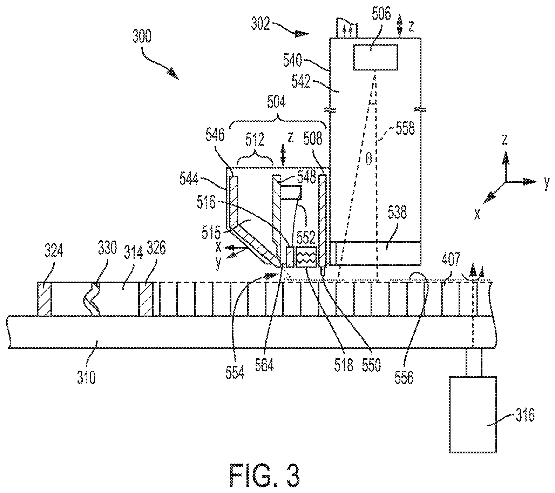

FIG. 3 shows a side view of a manufacturing apparatus 300 including details of the build unit 302, which is pictured on the far side of the build platform. The mobile build unit 302 includes an irradiation beam directing mechanism 506, a gas-flow mechanism 532 with a gas inlet and gas outlet (not shown) providing gas flow to a gas flow zone 538, and a powder recoating mechanism 504. In this example, the flow direction is substantially along the X direction. Above the gas flow zone 538, there may be an enclosure 540 that contains an inert environment 542. The powder recoating mechanism 504, which is mounted on a recoater plate 544, has a powder dispenser 512 that includes a back plate 546 and a front plate 548. The powder recoating mechanism 504 also includes at least one actuating element 552, at least one gate plate 516, a recoater blade 550, an actuator 518 and a recoater arm 508. In this embodiment, the actuator 518 activates the actuating element 552 to pull the gate plate 516 away from the front plate 548, as shown in FIG. 3. There is also a gap 564 between the front plate 548 and the gate plate 516 that allows the powder to flow onto the rotating build platform 310 when the gate plate 516 is pulled away from the front plate 548 by the actuating element 552. The rotating build platform 310 may be rotatably controlled by a motor 316.

FIG. 3 shows a build unit 302 with the gate plate 516 at an open position. The powder 515 in the powder dispenser 512 is deposited to make a fresh layer of powder 554, which is smoothed over a portion of the top surface (i.e. build or work surface) of the rotating build platform 310 by the recoater blade 510 to make a substantially even powder layer 556 which is then irradiated by the irradiation beam 558 to a fused layer that is part of the printed object 330. In some embodiments, the substantially even powder layer 556 may be irradiated at the same time as the build unit 302 is moving, which allows for a continuous operation of the build unit 302 and hence, a more time-efficient production of the printed or grown object 330. The object being built 330 on the rotating build platform 310 is shown in a powder bed 314 constrained by an outer build wall 324 and an inner build wall 326. In this particular illustration of one embodiment of the present invention, the gas flow in the gasflow zone 532 flows in the x direction, but could also flow in any desired direction with respect to the build unit.

It is noted that while the abovementioned selective powder recoating mechanism 504 only includes a single powder dispenser, the powder recoating mechanism may include multiple compartments containing multiple different material powders are also possible.

One advantage of the abovementioned additive machines is that, in some embodiments, the build plate may be vertically stationary (i.e. in the z direction). This permits the build plate to support as much material as necessary, unlike the prior art methods and systems, which require some mechanism to raise and lower the build plate, thus limiting the amount of material that can be used. Accordingly, large scale additive machines are particularly suited for manufacturing an object within a large build envelope. With respect to the build envelope, precision and quality of the envelope may be relatively unimportant, such that rapid build techniques are advantageously used. In general, the build envelope may be built by any suitable means, for instance by Mig or Tig welding, or by laser powder deposition. If the wall is built by additive manufacturing, then a different irradiation emission directing device can be used to build than wall than is used to build the object. This is advantageous because building the wall may be done more quickly with a particular irradiation emission directing device and method, whereas a slower and more accurate directing device and method may be desired to build the object.

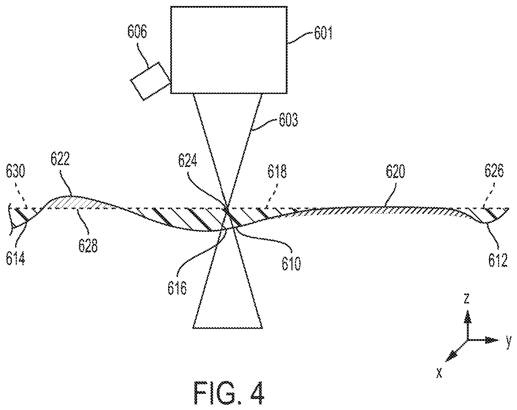

While the build(s) solidify powder or a build material to build a component (e.g. 330, 415), stresses within the solidified portion of the build may result in areas of the build being higher or lower in the z direction than desired. A controller may be provided (not shown) that includes a processor to determine the topology of the build surface as a build progresses. FIG. 4 represents a simplified view of an AM build and/or surface 620, a converging energy source 603, an energy source directing mechanism 601, and a camera 606 for monitoring a build and/or detecting a mark and/or energy source dimension. It is noted that the energy source 603 may comprise any of the abovementioned energy sources and may be used to at least partially solidify a build material. It is further noted that in one example, the energy source directing mechanism may 601 be the abovementioned irradiation beam directing mechanism 401 and/or 506 of build units 400 and 302. Further, the energy source directing mechanism may be a stationary source in a conventional additive manufacturing apparats (e.g. 120, and/or 130 in FIG. 1).

Turning to FIG. 4, as a build progresses, a surface of the build material and/or build itself may begin to protrude from a build surface. For consistency purposes, any portion of a build surface (e.g. build material and/or solidified build) that protrudes past, or higher in a z-direction, than an expected plane and/or z-height 618 of the build will be referred to as a protrusion. Conversely, any portion of a build surface (e.g. build material and/or solidified build) that is lower in a z-direction that expected plane and/or z-height 618 in the z-direction will be referred to as a depressed region (e.g. 610, 612, and 614). The term build material may include the component itself, and or the build material, which may include all known mediums for additive manufacturing. Non-limiting examples of which include metallic powders (as discussed above), foils, polymers, plastics and/or ceramics.

The controller (not shown) of an AM apparatus which includes a processor, may calculate and/or be programmed with an expected height of the build and/or z-height of the build material surface 618. In order to determine if portions of the surface fall within the expected z-height range, a converging energy source 603 may be focused so that the beam converges at a known point. By controlling the convergence point of the beam, either a beam dimension and/or a mark formed on the build material by the beam may be known and compared with a known beam dimension at the expected z-height 618. For example, it may be known that when a focal point of the converging energy source is set to a specific value, a beam and/or mark at point 624 on the build surface formed by the beam would have a specific dimension if the build surface is at the expected plane 618. A camera 606 may be focused so as to detect a dimension of a mark formed on the surface of the build by the energy source and/or a dimension of the energy source itself. However, if a build surface has a depression (i.e. is at a negative z-value with relation to the expected plane 618), the beam and/or mark at point 616 would have a dimension larger than at a point 624. Thus, in the abovementioned situation the determination may be made that the build surface 610 is lower in a z-direction than expected and is thus depressed when compared to the expected plane 618. Once it is determined that the build surface 610 is lower in a z-direction that expected and/or than the rest of the build surface, the AM apparatus modifies the build to deposit more build material and/or to add and solidify additional layers of build material to the depressed region 610 so that the depressed region of the build material falls within a correct z-height. Similarly, as shown in FIG. 4, other depressed regions 630 and 612, which fall below the correct z-height 630 and 626 may be processed in a similar manner.

As another example, several marks at portions 612, 614 and/or 616 may be detected by the camera 606, and the overall topography of the build surface may be determined. A computer-aided design (CAD) file may be created based on the topology within the established footprint or lowest locations. The controller may establish a minimum and maximum Z-height of the surface topology. By establishing the minimum and maximum Z-height of the surface topology in a particular layer of the build, the topology map may be used to automatically alter the build file for a part within the footprint having inverse topology and height (Zmax-Zmin) at each of the portions 612-614. A topology compensating build, for example, may be appended at the next and/or further portions of the incumbent part build file. Portions of the build may also protrude from the build surface (i.e. extend in the positive z-direction). For example, at portion 622 the energy source may be used to form a mark on the build surface. The camera 606 detects the mark and a dimension of the mark detected by the camera. Based on the dimension detected by the camera 606, it may be determined that portion 622 extends above the correct z-height 628 and the dimension may be used to determine a topology of the surface at portion 622 of the build surface. The determined topology may then be used to automatically alter the build file for a part within the footprint having inverse topology and height (Zmax-Zmin) at portion 622. A topology compensating build, for example, may be appended at the next and/or further portions of the incumbent part build file. For example, if it is determined that surface 622 extends above the correct z-height, in subsequent layers less build material may be added and/or fused to region 622 than in regions of the build surface that are within the correct z-height. The energy source may be used to shot peen and or ablate the surface of the build at portion 622. For example, laser shot peening may be used to remove fused build material and reduce the z-dimension of portion 622 and/or to prepare the surface for the subsequent addition of build material. As another example, a laser may be used to ablate the surface to reduce the z-dimension of portion 622 of the build and/or to prepare the surface for the subsequent addition of build material.

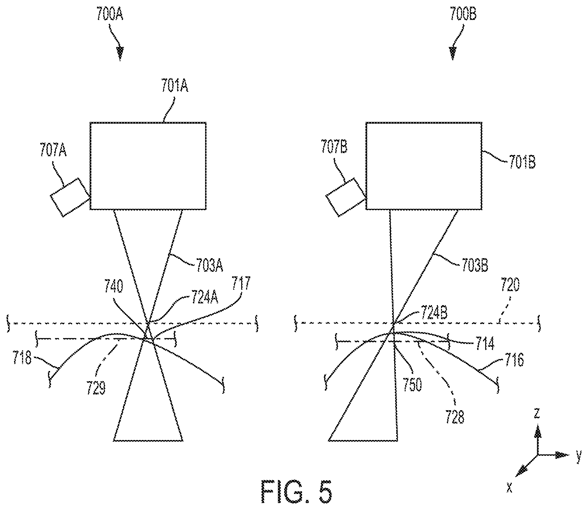

Another simplified example is shown in FIG. 5. FIG. 5 represents a simplified view of an AM build and/or surface 716 and/or 718, a converging energy source(s) 703A-B, energy source directing mechanism(s) 701A-B, and a camera(s) 707A-B for monitoring a build. It is noted that the energy source 603 may comprise any of the abovementioned energy sources and may be used to at least partially solidify a build material. It is further noted that in one example, the energy source directing mechanism 701A-B may be the abovementioned irradiation beam directing mechanism 401 and/or 506 of build units 400 and 302. Further, the energy source directing mechanism may be a stationary source in a conventional additive manufacturing apparats (e.g. 120, and/or 130 in FIG. 1). Further, it is noted that 700A and 700B may represent two different energy sources and/or cameras or may represent a single energy source and/or camera that is moved from a first location (represented by 700A) to a second location (represented by 700B). Further, 700A and 700B a single energy source and/or camera at two different layers of the build process. For example, a first layer (represented by 700A) to a second subsequent layer (represented by 700B).

The controller (not shown) of an AM apparatus which includes a processor, may calculate and/or be programmed with an expected height of the build and/or build material surface 729. In order to determine if portions of the surface fall within the expected z-height range, a converging energy source 703A may be focused so that the beam converges at a known point 724A. It is noted that while the converging point 724A in this example is shown above the expected z-height range, the converging point 724A may be located in any desired location (e.g., below, or at the expected z-height). By controlling the convergence point of the beam, a mark formed on the build material by the beam at portion 717 may be known and compared with a known mark dimension at the expected z-height 729. Further, the controller may determine the dimension of the mark when the surface is at the correct z-height by comparing the dimension of the beam and/or mark at several locations on one layer and/or by comparing the dimension of the beam and/or mark at a single location at a previous layer and subsequent layer of the build. For example, it may be known that when a focal point of the converging energy source is set to specific location e.g. 724A, a beam and/or mark at a correct z-height 740 would have a specific dimension. A camera 707A may be focused so as to detect a dimension of an actual mark 717 formed on the surface of the build 718 by the energy source 703A and/or a dimension of the energy source itself. However, if a build surface is below the expected z-height (i.e. is at a negative z-value with relation to the expected z-height 729), the beam and/or mark at point 717 would have a dimension larger than at a point 740. Thus, in the abovementioned situation the determination may be made that the build surface 717 is lower in a z-direction than expected. Once it is determined that the build surface 717 is lower in a z-direction than expected, the AM apparatus may modify the build to deposit more build material and/or to add and solidify additional layers of build material to the lower portion of the build 717 so that region 717 of the build material falls within a correct z-height.

In the above example, the energy source may be used to produce several marks on the build surface at differing locations, by reading the marks with camera 707A and/or 707B, the overall topography of the build surface may be determined. A computer-aided design (CAD) file may be created based on the topology within the established footprint or lowest locations. The controller may establish a minimum and maximum Z-height of the surface topology. By establishing the minimum and maximum Z-height of the surface topology in a particular layer of the build, the topology map may be used to automatically alter the build file for a part within the footprint having inverse topology and height (Zmax-Zmin) at each of the portions that fall out of the expected z-height range. A topology compensating build, for example, may be appended at the next and/or further portions of the incumbent part build file.

Portions of the build may also protrude from the build surface (i.e. extend in the positive z-direction). For example, at portion 714 the energy source may be used to form a mark on the build surface 716. The camera 707B detects the mark and a dimension of the mark. In this example, the point at which the energy source converges 724 may be above the expected z-height 750 of the build surface, such that a mark formed by the energy source formed at the expected z-height would have specific dimension. It is noted that the point at which the energy source converges 724 may also be above the expected build surface or at the expected build surface. In the above example, if the detected dimension is smaller at the actual build surface 714 it may be determined that portion 714 extends above the expected an/or average z-height 750 and the dimension may be used to determine a topology of the surface at portion 750 of the build surface. The determined topology may then be used to automatically alter the build file for a part within the footprint having inverse topology and height (Zmax-Zmin) at portion 750. A topology compensating build, for example, may be appended at the next and/or further portions of the incumbent part build file. For example, if it is determined that surface 750 extends above the correct z-height, in subsequent layers less build material may be added and/or fused to region 750 than in regions of the build surface that are within the correct z-height. The energy source may be used to shot peen and or ablate the surface of the build at portion 750. For example, laser shot peening may be used to remove fused build material and reduce the z-dimension of portion 750 and/or to prepare the surface for the subsequent addition of build material. As another example, a laser may be used to ablate the surface to reduce the z-dimension of portion 750 of the build and/or to prepare the surface for the subsequent addition of build material.

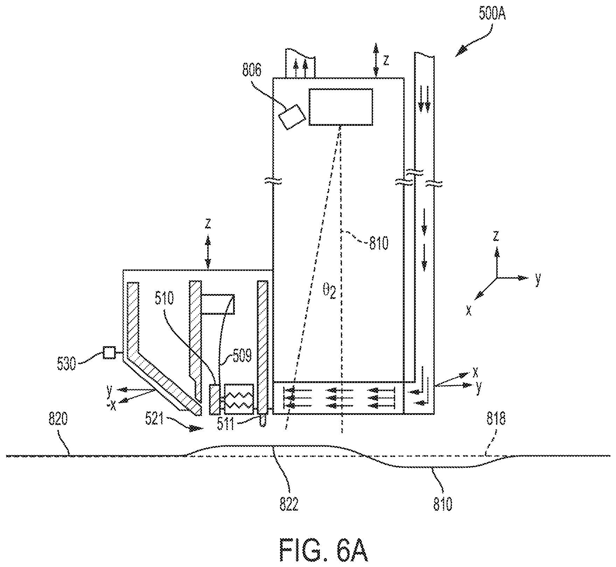

FIGS. 6A-=C show various examples of methods in which a build surface may be recovered. The build unit 500A-B may be mobile as discussed in detail above. The build unit may further include a camera 806 and may optionally include a height sensor 530 for determining the topology of a build platform prior to a build process. Further, the topography of the build surface and/or build platform may be further determined using a laser interferometry process.

As shown in FIGS. 6A-=C , at a particular layer of the build, a build surface may include a single or plurality of protrusions 822 and and/or depressed regions 810 that fall outside of an acceptable z-height range. A build unit 500 may be positioned at a first location above a build surface 820. Either before and/or after depositing a layer of build material, a similar process as mentioned above may be performed at a surface 822 of the build. For example, a mark may be formed on the build surface 822 and the dimension of the mark may be detected by the camera 806. Based on the dimension of the mark, it may be determined that the build surface at region 822 extends above an expected or average z-height of the build surface 820. A similar process may be performed in portion 810. Based on the dimension of the mark detected by the camera 806, it may be determined that the build surface at portion 810 is below an expected or average z-height of the build surface 818. The topology of the build surface may be determined based on an estimate z-height and/or may be based on the detection of a plurality of marks and an average size of the mark's detected by the camera. Further, the topology may be determined by monitoring a change in the size of marks at fixed locations in the x/y direction as the build progresses.

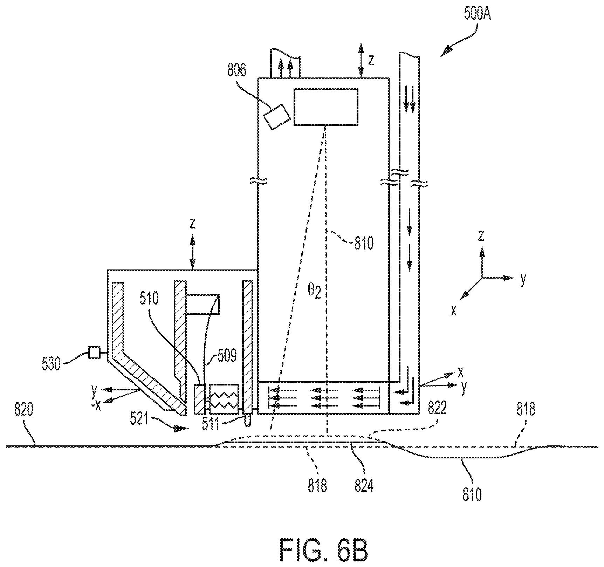

As shown in FIG. 6B, once it is determined that a portion of the build surface extends higher than an acceptable level in the z-direction, the energy source 810 may be used to shot peen and or ablate the surface of the build at portion 822. For example, laser shot peening may be used to remove fused build material and reduce the z-dimension of portion 822 to a more acceptable dimension 824 and/or to prepare the surface for the subsequent addition of build material. As another example, a laser may be used to ablate the surface to reduce the z-dimension of portion 822 to a more acceptable dimension 824 and/or to prepare the surface for the subsequent addition of build material.

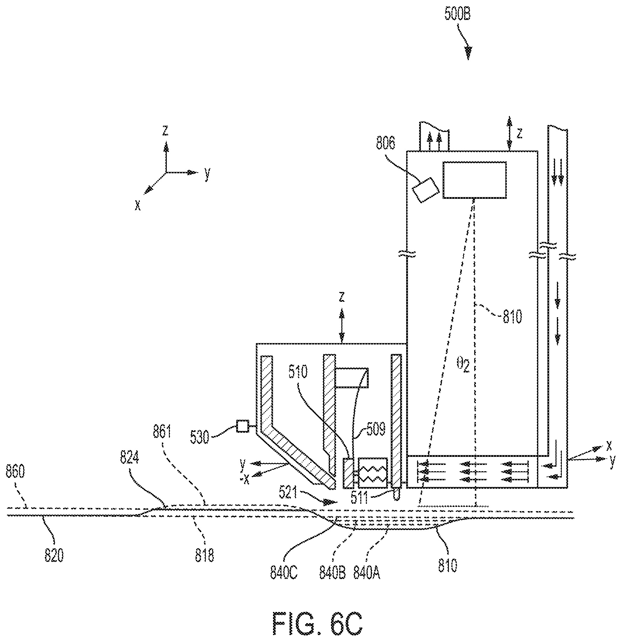

In combination with the abovementioned process, the determined topology may be used to automatically alter the build file for a part within the footprint having inverse topology and height (Zmax-Zmin) at portion 822. A topology compensating build, for example, may be appended at the next and/or further portions of the incumbent part build file. For example, if it is determined that surface 822 extends above the correct z-height, in subsequent layers less build material may be added and/or fused to region 822 (i.e. as shown by ref. 861 in FIG. 6C) than in regions of the build surface that are within the correct z-height (i.e. as shown by ref 860 in FIG. 6C).

As shown in FIG. 6C, a low portion of the build surface 810 may be at least partially solidified and recoated first by the build unit at location 500B. A solidification and recoating process at the lowest location 810, for example, may be repeated several times 840A-C before portions of the build surface that fall within an acceptable z-height range 820 are solidified and recoated with build material 860. The building of additional layers at the lowest location may be repeated until the build surface is a unified layer. Then, the controller may be configured to automatically continue the build of the object when the z-height across the build surface is within an acceptable range.

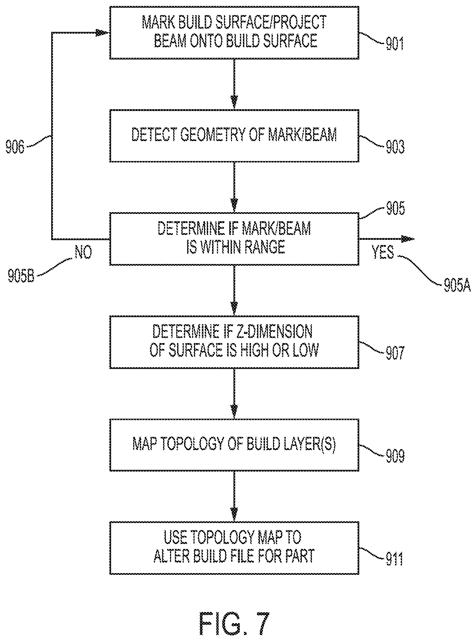

FIG. 7 is a block diagram illustrating a build surface correction process not encompassed by the wording of the claims. At a point during a build process, the energy source may be used to mark the build surface at step 901. The geometry of the mark may be detected in step 903 and the determination made if the mark is within 905A or outside 905B an acceptable range based on the detected geometry. If the determination is made that the mark is within an acceptable range the build may continue and/or another portion of the surface may be marked to determine the z-height at another location. If the determination is made that the geometry of the mark is larger and/or smaller than an acceptable range, the build process may continue, however in a subsequent layer of the build the surface may be marked again and the change in the dimension may be determined to establish if the z-dimension of the portion of the build is high or low at step 907. As an alternative, it may be established that the z-dimension of the build is high or low based on a single marking and detecting operation. After the determination is made that the portion of the build is high or low, the process may be repeated at a plurality of locations over the build surface, and the topology of the build layer may be mapped. Once the topology of the surface is mapped, the topology information may be used to alter the build file for the component to decrease or eliminate z-height variations in the build at step 911 using any one of the methods discussed above. According to an aspect, in step 911, a computer-aided design (CAD) file may be created based on the topology within the established footprint or lowest locations of the build surface. The controller may establish a minimum and maximum z-height of the footprint surface topology. By establishing the minimum and maximum z-height of the footprint surface topology, the topology map may be used to automatically alter the build file for a part within the footprint having inverse topology and height (Zmax-Zmin). A topology compensating build may be appended and applied when forming subsequent layers of the build.

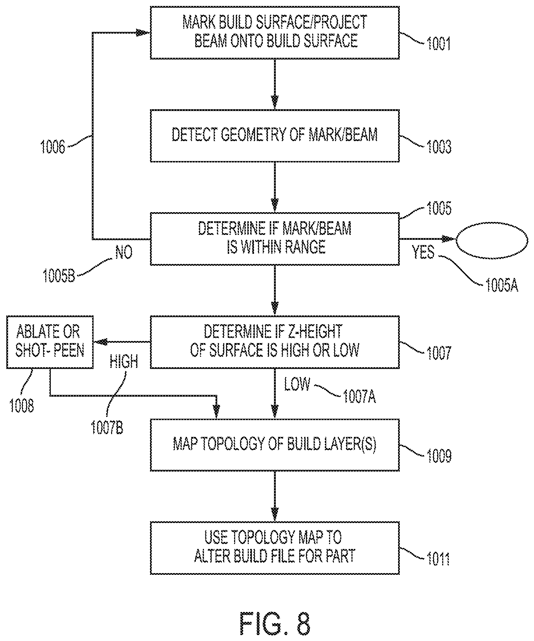

FIG. 8 is a block diagram illustrating a build surface correction process in accordance with one aspect of the disclosure. At a point during a build process, the energy source is used to mark the build surface at step 1001. The geometry of the mark may be detected in step 1003 and the determination made if the mark is within 1005A or outside 1005B an acceptable range based on the detected geometry. If the determination is made that the mark is within an acceptable range the build may continue and/or another portion of the surface may be marked to determine the z-height at another location. If the determination is made that the geometry of the mark is larger and/or smaller than an acceptable range, the build process may continue, however in a subsequent layer of the build the surface may be marked again and the change in the dimension may be determined to establish if the z-dimension of the portion of the build is high or low at step 1007. As an alternative, it may be established that the z-dimension of the build is high or low based on a single marking and detecting operation. If the determination is made that the z-height of the surface is high 1007B, a shot peening and/or ablation process are performed on the portion of the surface that is high in step 1008. Step 1008 may be repeated at all high location of the build surface and/or may only be applied to portion of the build surface that are above a certain threshold z-value. After the determination is made that the portion of the build is high or low, the process may be repeated at a plurality of locations over the build surface, and the topology of the build layer may be mapped in step 1009. Once the topology of the surface is mapped, the topology information may be used to alter the build file for the component to decrease or eliminate z-height variations in the build at step 1011 using any one of the methods discussed above. According to an aspect, in step 1011, a computer-aided design (CAD) file may be created based on the topology within the established footprint or lowest locations of the build surface. The controller may establish a minimum and maximum z-height of the footprint surface topology. By establishing the minimum and maximum z-height of the footprint surface topology, the topology map may be used to automatically alter the build file for a part within the footprint having inverse topology and height (Zmax-Zmin). A topology compensating build may be appended and applied when forming subsequent layers of the build.

This written description uses examples to disclose the invention, including the preferred embodiments, and also to enable any person skilled in the art to practice the invention, including making and using any devices or systems and performing any incorporated methods. The patentable scope of the invention is defined by the claims. Aspects from the various embodiments described, as well as other known equivalents for each such aspect, can be mixed and matched by one of ordinary skill in the art to construct additional embodiments and techniques in accordance with principles of this application.

## Claims

1. A method of fabricating an object by additive manufacturing comprising:
determining the topography of a surface (620) of a build material and/or build and determining a location of a depressed area (610) of the build surface (620) based on the determined topography of the build surface (620), the build surface being a layer of build material used to form the object, the build material being at least one of a powder and a foil; and
filling in the depressed area (610) in order to reduce variations in the topography of the build surface (620), wherein determining the topography of the surface comprises:
marking the surface (620) with a first mark using a converging energy source (603);
determining a dimension of the mark using a camera (606); and
determining a height of the first mark based on the dimension of the mark; and
wherein the filling in the depressed area comprises:
(a) depositing a layer of build material over a depressed area (610) of the build surface (620); and
(b) fusing at least a portion of the layer of build material at the depressed area (610) of the build surface (620);
(c) depositing a subsequent layer of powder over the depressed area (610) of the build surface (620); and
(d) repeating steps (a)-(c) until the filling in of the depressed areas is complete; wherein the additive manufacturing process further comprises:
determining a location of protruded area (622) of the surface based on the determined topography; and
performing a leveling operation to the surface to reduce variations in the topography of the build surface; wherein the leveling operation comprises:
performing at least one of an ablation process and a shot peening process to the protruded area.

2. The method of fabricating an object in accordance with claim 1, wherein before at least one of steps (c) and (d), the topology of the surface is determined, wherein determining the topology of the surface further comprises:
marking the surface with a second mark using the converging energy source;
determining a second dimension of the second mark using the camera; and
comparing the first dimension to the second dimension.

## Patentansprüche

1. Verfahren zum Herstellen eines Gegenstands mittels additiver Fertigung, umfassend:
Bestimmen der Topographie einer Oberfläche (620) eines Baumaterials und/oder eines Aufbaus und Bestimmen einer Lage eines vertieften Bereichs (610) der Bauoberfläche (620) auf Grundlage der bestimmten Topographie der Bauoberfläche (620), wobei die Bauoberfläche eine Schicht aus Baumaterial ist, die zum Bilden des Gegenstands verwendet wird, wobei das Baumaterial wenigstens eines von einem Pulver und einer Folie ist; und
Auffüllen des vertieften Bereichs (610), um Variationen in der Topographie der Bauoberfläche (620) zu verringern, wobei das Bestimmen der Topographie der Oberfläche umfasst:
Markieren der Oberfläche (620) mit einer ersten Markierung unter Verwendung einer konvergierenden Energiequelle (603);
Bestimmen einer Abmessung der Markierung unter Verwendung einer Kamera (606); und
Bestimmen einer Höhe der ersten Markierung auf Grundlage der Abmessung der Markierung; und
wobei das Auffüllen des vertieften Bereichs umfasst:
(a) Abscheiden einer Schicht aus Baumaterial über einem vertieften Bereich (610) der Bauoberfläche (620); und
(b) Verschmelzen wenigstens eines Abschnitts der Schicht aus Baumaterial an dem vertieften Bereich (610) der Bauoberfläche (620);
(c) Abscheiden einer nachfolgenden Pulverschicht über dem vertieften Bereich (610) der Bauoberfläche (620); und
(d) Wiederholen der Schritte (a) bis (c), bis das Auffüllen der vertieften Bereiche abgeschlossen ist; wobei das additive Fertigungsverfahren ferner umfasst:
Bestimmen einer Lage eines hervorstehenden Bereichs (622) der Oberfläche auf Grundlage der bestimmten Topographie; und
Durchführen eines Nivelliervorgangs an der Oberfläche, um Variationen in der Topographie der Bauoberfläche zu verringern; wobei der Nivelliervorgang umfasst:
Durchführen wenigstens eines von einem Ablationsverfahren und einem Kugelstrahlverfahren an dem hervorstehenden Bereich.

2. Verfahren zum Herstellen eines Gegenstands nach Anspruch 1, wobei vor wenigstens einem der Schritte (c) und (d) die Topologie der Oberfläche bestimmt wird, wobei das Bestimmen der Topologie der Oberfläche ferner umfasst:
Markieren der Oberfläche mit einer zweiten Markierung unter Verwendung der konvergierenden Energiequelle;
Bestimmen einer zweiten Abmessung der zweiten Markierung unter Verwendung der Kamera; und
Vergleichen der ersten Abmessung mit der zweiten Abmessung.

## Revendications

1. Procédé de fabrication d'un objet par fabrication additive, comprenant :
la détermination de la topographie d'une surface (620) d'un matériau de construction et/ou d'une construction et la détermination d'un emplacement d'une zone en creux (610) de la surface de construction (620) sur la base de la topographie déterminée de la surface de construction (620), la surface de construction étant une couche de matériau de construction utilisée pour former l'objet, le matériau de construction étant au moins l'un parmi une poudre et une feuille ; et
le remplissage de la zone en creux (610) afin de réduire des variations de la topographie de la surface de construction (620), dans lequel la détermination de la topographie de la surface comprend :
le marquage de la surface (620) avec une première marque en utilisant une source d'énergie convergente (603) ;
la détermination d'une dimension de la marque en utilisant une caméra (606) ; et
la détermination d'une hauteur de la première marque sur la base de la dimension de la marque ; et
dans lequel le remplissage de la zone en creux comprend :
(a) le dépôt d'une couche de matériau de construction sur une zone en creux (610) de la surface de construction (620) ; et
(b) la fusion d'au moins une partie de la couche de matériau de construction au niveau de la zone en creux (610) de la surface de construction (620) ;
(c) le dépôt d'une couche subséquente de poudre sur la zone en creux (610) de la surface de construction (620) ; et
(d) la répétition des étapes (a) à (c) jusqu'à ce que le remplissage des zones en creux soit terminé ; dans lequel le procédé de fabrication additive comprend en outre :
la détermination d'un emplacement d'une zone en saillie (622) de la surface sur la base de la topographie déterminée ; et
la réalisation d'une opération de nivellement sur la surface afin de réduire des variations de la topographie de la surface de construction ; dans lequel l'opération de nivellement comprend :
la réalisation d'au moins l'un parmi un procédé d'ablation et un procédé de grenaillage sur la zone en saillie.

2. Procédé de fabrication d'un objet selon la revendication 1, dans lequel, avant au moins l'une des étapes (c) et (d), la topologie de la surface est déterminée, dans lequel la détermination de la topologie de la surface comprend en outre :
le marquage de la surface avec une seconde marque en utilisant la source d'énergie convergente ;
la détermination d'une seconde dimension de la seconde marque en utilisant la caméra ; et
la comparaison de la première dimension avec la seconde dimension.
